# EUROPEAN PATENT APPLICATION

(11) **EP 3 486 766 A1**
(43) Date of publication of application: **22.05.2019**
(21) Application number: 17202216.2
(22) Date of filing: 17.11.2017
(51) Int. Cl.: G06F 8/35, G06F 11/36, G06F 17/50, G06Q 30/08

(54) **COMPUTER-IMPLEMENTED METHOD OF AUGMENTING A SIMULATION MODEL OF A PHYSICAL ENVIRONMENT OF A VEHICLE**

(71) Applicant: Steinbeis Interagierende Systeme GmbH, 73728 Esslingen (DE)
(72) Inventor: Ulmer, Daniel, 71083 Herrenberg (DE); Bühler, Oliver, 73271 Holzmaden (DE); Wittel, Steffen, 75392 Deckenpfronn (DE)
(74) Representative: Meyer zu Bexten, Elmar

(57) **Abstract**

As per a known runtime validation method for driver assistance systems and autonomous driving, situations and settings within the physical environment need to be scanned by real vehicles in such a way that they are usable to test new algorithms. To this end, a simulation model of the physical environment of the so-called ego-vehicle is complemented with the scans of these known settings. Consequently, only such settings are eventually available that have been recorded by test drivers - or later production cars - and thus exist in real terms. Furthermore, the resulting scans are limited, for example, to a specific sensor technology, certain approach angle, and random weather conditions under which they happened to be captured.

**Solution**

The problem is solved by establishing a deficiency of the simulation model, the deficiency pertaining to a certain setting within the physical environment, issuing instructions for capturing a scan of the setting, receiving the scan, and remedying the deficiency by complementing the simulation model with the scan.

## Description

### Technical Field

The invention relates to the process and products as per the first portion of the independent claims.

### Background Art

Model-based design (MBD) is a mathematical and visual method of addressing problems associated with designing complex control, signal processing, or communication systems. MBD is commonly used in designing embedded software in many motion control, industrial equipment, aerospace, and automotive applications. The underlying paradigm is significantly different from traditional design methodology. Rather than using complex structures and extensive software code, designers use MBD to define so-called plant models with advanced functional characteristics using continuous-time and discrete-time building blocks. When used with suitable simulation tools, these models allow rapid prototyping, software testing, and verification.

More specifically, automotive simulation models are employed for the real-time simulation of passenger cars and trucks as well as their components. Such models effectively serve as plant models for the development and testing of engine controls, vehicle dynamics controls, on-board power electronics, and driver assistance systems. They are considered particularly useful for hardware-in-the-loop (HIL) testing of electronic control units (ECUs) or during the design phase of controller algorithms for early validation.

For instance, US 2017168809 A (INTEL CORP [US]) 15.06.2017 proposes technologies for customized crowd-sourced validation that includes a computing device having an engine that receives user information from one or more user devices, executes a model for an autonomous system such as a self-driving vehicle with the user information to generate behavior data of the model, and generates a software update for the model based on the behavior data. The user information may include sensor data, such as distance detection sensor data. The computing device may transmit an incentive such as a software update, feature update, or safety software update to the user devices. The computing device may also receive information associated with the model from one or more developer devices.

The preamble of Claim 1 is based on a different runtime validation method for advanced driver assistance systems (ADAS) introduced in WACHENFELD, Walther, et al. Virtual Assessment of Automation in Field Operation - A New Runtime Validation Method. 10. Workshop Fahrerassistenzsysteme. 2015, p.161.

### Summary of invention

The invention as claimed is hereinafter disclosed in such a way that the technical problem with which it deals can be appreciated and the solution can be understood.

### Technical Problem

As per the prior art, situations and settings within the physical environment need to be scanned by real vehicles in such a way that they are usable to test new algorithms. To this end, a simulation model of the physical environment of the so-called ego-vehicle is complemented with the scans of these known settings. Consequently, only such settings are eventually available that have been recorded by test drivers - or later production cars - and thus exist in real terms. Furthermore, the resulting scans are limited, for example, to a specific sensor technology, certain approach angle, and random weather conditions under which they happened to be captured.

### Solution to Problem

The problem is solved as per the characterizing portion of the independent claims.

### Advantageous effect of invention

Setting, weather, maneuvering process, and sensor technology are effectively decoupled so that the individual aspects may be determined separately and thus combined differently in the simulation. On the one hand, this modular approach allows for an increase in test depth; on the other hand, it aids in decoupling the tasks of simulation or test and scanning of the setting both technically and economically. An important aspect here is to decouple the real settings so that they can be scanned without expert knowledge - which would require a test driver - and made available to the tester in an economically feasible manner.

### Description of embodiments

Common expectations regarding a simulation of a physical environment of an ego-vehicle include, for example, that a certain model quality is achieved, that hardware suppliers or carmakers can demonstrate the quality of their sensors in certain situations, or that these stakeholders can show that their vehicle or algorithm can cope with a certain driving route anywhere in the world, e. g., for legal or marketing reasons. Specifically, employees of an original equipment manufacturer (OEM), top-tier supplier, or other stakeholders in the model share expectations regarding the model or use it in simulation and are interested in the best model quality achievable to demonstrate the capabilities of their future products in a realistic context.

To this end, the respective stakeholder may perform a modularized simulation, encompassing modules such as "environment-geography", "environment-weather", "traffic", "surrounding objects", "sensors", or "vehicle". This modularized simulation comprises a method for the detection or localization of a deficiency. Such deficiency in turn is related to the environment, to geography, to the weather, and to an object. The module responsible in the context of the simulation, which usually models a sensor or other field device, consists of an input interface and output interface, whereas the setting in which the deficiency occurs is described by sensor properties, environment-geography, environment-weather, or surrounding object. Hence, these terms in their entirety describe a deficiency consisting of the input/output interfaces of the deficient model and a description of the setting to which the deficiency pertains.

Such a deficiency can be communicated to a portal or other Web-based service which implements and decouples various business models - for instance, a subscription or one-time charge for stakeholders, reference simulation, or communities of participating players and hardware developers - as well as their technical representation (login, payment, participation as a player, or acceptance of a challenge). The communities mentioned consist of many people from anywhere in the world who share an interest in seeing or capturing real objects and phenomena from the angle of a machine. From a business perspective, the stakeholder submitting the deficiency would typically be considered the primary client of the portal.

In an optional step, as the stakeholder may perform a different simulation than is used in the portal or by third parties, the setting is first simulated by means of a reference simulation within the portal. That is, in the present embodiment, a simulated sensor having a comparable input/output interface is transposed into the described setting containing the described object, and thus the deficiency is verified and visualized. To a participant, this visualization may eventually serve as confirmation in case the visualization is improved with his data. Furthermore, the reference simulation is used to fix a price which is transmitted to the stakeholder (provided he or she has no flat rate). This price depends on the difficulty of the problem, hardware requirements, number of participants, weather conditions and location of the scan, etc.

Finally, the portal checks whether similar scans are already available or whether one scan can be plausibly verified by a second scan. For example, the portal may have a metal post in the rain captured in two cities even if only one is desired. Alternatively, the stakeholder may be offered a different scan to replace the desired one. In this context, by scan is meant any technical image of an object in a certain place, captured with a certain sensor technology - such as optical, stereo-optical, or ultrasound -, under certain weather conditions and conditions of movement, such as on foot, by bicycle, or by car.

If an order is placed, a field campaign is mounted, posing a challenge to be met among the community by, for example, capturing a scan of the respective object at a certain location with a specific scanning technology. Participants in this campaign compete against each other for who captures the best or most scans. Such competition can be promoted by monetary or status gifts such as a test drive in a car, travel, or financial incentive. In preparation for this campaign, the portal determines how many participants have access to the appropriate hardware and desired location(s) to capture a scan. In addition, instructions are issued that call for a certain relative height, speed, angle, or distance between the hardware and the object. Both fixed awards and auctions ("who does it cheapest") or rising bids may be applied.

As an alternative, rewards may be posted for uploading such phenomena that push existing ADAS algorithm to their limits. In this scenario, the instructions do not refer to any specific location, but participants are incentivized to freely explore their environment. For example, a camp chair in a parking space may pose a practical challenge to an assistance system. A participant who captures this setting would then find out via the server whether an OEM properly handles this setting using a proprietary sensor set, being awarded a bonus if that test fails.

In an advanced embodiment, differences between varying software contributions to sensor data may be determined automatically to supply the respective stakeholder with a suitable adapter. That adapter, for instance, may manipulate an actual experiment using a first variant of said software such that the driver experiences the experiment as if a second variant was installed.

Furthermore, stakeholders may be given the possibility to compare the sensors of different top-tier suppliers within their proprietary vehicle configuration using realistic sensor data. To this end, a stakeholder would not dictate a specific manoeuvre; rather, a setting that exposes maximum differences between, e. g., two sensor variants would be determined automatically.

In yet another type of campaign may serve to motivate participants to identify and possibly engineer additional hardware that may improve ADAS performance.

In this context, it should be noted that not every sensor is currently available for mobile devices. Sensor hardware can thus be provided by stakeholders or even be developed by participants themselves striving to deliver the best scan. Consequently, in case of a challenge, it is first examined whether the necessary hardware is available. If so, the campaign may be mounted unless coverage is considered insufficient, in which case negotiation with the originating client for an increased price or upselling to a hardware campaign may ensue. If the required hardware is entirely unavailable, the hardware community may be challenged, increasing the stakeholder price accordingly, or suppliers may be offered a hardware campaign, in which case the main field campaign is put on hold until suitable hardware becomes available. If it becomes apparent that participants are required to acquire new hardware, the portal may offer an additional incentive to participants who perform the respective upgrade, such as bonus credit or additional job volume.

If one or more participants provide a scan, each scan is validated such as to check whether it was captured in the right weather - for instance, rain. This validation may be achieved by comparing two scans or using more sensors than required, e. g., an additional camera, humidity, or temperature sensor. The scan is further verified in the reference simulation and checked for adherence to the capturing instructions and plausibility criteria. In case of success, the respective participant is rewarded by booking the stipulated premium to his player's account.

In an alternative business case, the end user and potential car buyer may take the role of the portal's customer. For example, a stakeholder - equipped with a set of models based on real-world scans of a certain route - may simulate a drive on that route. This way, he could prove the feasibility of a desired level of driving automation to the prospective buyer with respect to, for instance, that person's daily commute. With the potential of autonomous driving largely depending on weather and road conditions, a single test drive of a specific car model in good weather would be of limited value for the purchase decision at issue. Using an embodiment of the invention though, the customer might simply select within the portal his route and the range of weather, traffic, and other conditions upon which the simulation should be based, thereby inviting various OEMs to offer a virtual "test drive" on the given route under the given conditions.

### Industrial applicability

The invention may be applied, inter alia, throughout the automotive and supplying industries.

### Citation list

The following documents are cited hereinbefore.

### Patent literature

US 2017168809 A (INTEL CORP [US]) 15.06.2017

### Non-patent literature

WACHENFELD, Walther, et al. Virtual Assessment of Automation in Field Operation - A New Runtime Validation Method. 10. Workshop Fahrerassistenzsysteme. 2015, p.161.

## Claims

1. Computer-implemented method of augmenting a simulation model of a physical environment of an ego-vehicle,
**characterized in**
establishing a deficiency of the simulation model, the deficiency pertaining to a certain setting within the physical environment,
issuing instructions for capturing a scan of the setting,
receiving the scan, and
remedying the deficiency by complementing the simulation model with the scan.

2. Method as per Claim 1
wherein
the setting is defined in terms of a certain location, terrain, weather conditions, and physical object present within the setting.

3. Method as per Claim 2
wherein
the instructions call for certain sensor hardware to be employed in the capturing and certain boundary conditions to be met by the scan, such as relative height, speed, angle, or distance between the hardware and the object.

4. Method as per Claim 3
wherein
the deficiency is established by a client and communicated to a server,
by issuing the instructions, preferably through a Web portal, to a community of participants, the server mounts a field campaign among said community to capture the scan, and
upon following the instructions, at least one of the participants uploads the scan to the server.

5. Method as per Claim 4
wherein
prior to mounting the campaign, the server verifies the deficiency by re-simulating the setting in an equally defective reference model and
upon receipt, the server verifies the scan by complementing the defective reference model therewith and, if successful, awards a stipulated premium, such as gratuity, credits maintained by the server, or an incentive event, to the uploading participant.

6. Method as per Claim 5
wherein
throughout the campaign, the server visualizes the deficiency based on the deficient reference model and,
when verifying the scan, the server presents a re-visualization based on the complemented reference model.

7. Method as per Claim 5 or Claim 6
wherein
the server quotes a price for the field campaign to the client based on the defective reference model, such as depending on severity of the deficiency, minimum number of the participants, certain aspects of the setting, or the called-for hardware.

8. Method as per any of Claim 5 through Claim 7
wherein,
when mounting the campaign, the server identifies members of the community having access to the called-for hardware and location.

9. Method as per any of Claim 5 through Claim 8
wherein,
when mounting the campaign, the premium is stipulated by means of bidding competition, auction, or at a fixed level.

10. Method as per any of Claim 4 through Claim 9
wherein
the hardware comprises at least one primary sensor, such as a radar, lidar, optical, stereo-optical, or ultrasonic sensing system, and auxiliaries, such as a camera, GPS, distance, distance to ground, orientation, temperature, or humidity sensor, preferably integrated in a mobile device such as a smartphone, tablet PC, or optical head-mounted display.

11. Method as per Claim 10
wherein
the scan is validated by means of the auxiliaries or comparison to further scans uploaded by the community or versus commercially available information such as weather forecasts.

12. Method as per any of Claim 4 through Claim 11
wherein,
when mounting the campaign, based on availability of prior scans, the server optionally substitutes the setting for a similar setting relevant to the pertinent deficiency.

13. Data processing apparatus having means for carrying out a method as per any of the preceding claims.

14. Computer program comprising instructions which, when the program is executed by a computer, cause the computer to carry out the steps of a method as per any of Claim 1 through Claim 12.

15. Computer-readable data carrier having stored thereon the computer program of Claim 14.

## Amended claims

### Amended claims in accordance with Rule 137(2) EPC.

1. Computer-implemented method of augmenting a simulation model of a physical environment of an ego-vehicle,
**characterized in**
establishing, by means of modularized simulation, a deficiency of the simulation model, the deficiency pertaining to a certain setting within the physical environment,
issuing instructions for capturing a scan of the setting,
receiving the scan, and
remedying the deficiency by complementing the simulation model with the scan.

2. Method as per Claim 1
wherein
the setting is defined in terms of a certain location, terrain, weather conditions, and physical object present within the setting.

3. Method as per Claim 2
wherein
the instructions call for certain sensor hardware to be employed in the capturing and certain boundary conditions to be met by the scan, such as relative height, speed, angle, or distance between the hardware and the object.

4. Method as per Claim 3
wherein
the deficiency is established by a client and communicated to a server,
by issuing the instructions, preferably through a Web portal, to a community of participants, the server mounts a field campaign among said community to capture the scan, and
upon following the instructions, at least one of the participants uploads the scan to the server.

5. Method as per Claim 4
wherein
prior to mounting the campaign, the server verifies the deficiency by transposing a simulated sensor having a comparable input/output interface into the described setting containing the described object, thus re-simulating the setting in an equally defective reference model and
upon receipt, the server verifies the scan by complementing the defective reference model therewith, checking for adherence to the capturing instructions and plausibility criteria, and, if successful, awards a stipulated premium, such as gratuity, credits maintained by the server, or an incentive event, to the uploading participant.

6. Method as per Claim 5
wherein
throughout the campaign, the server visualizes the deficiency based on the deficient reference model and,
when verifying the scan, the server presents a re-visualization based on the complemented reference model.

7. Method as per Claim 5 or Claim 6
wherein
the server quotes a price for the field campaign to the client based on the defective reference model, such as depending on severity of the deficiency, minimum number of the participants, certain aspects of the setting, or the called-for hardware.

8. Method as per any of Claim 5 through Claim 7
wherein,
when mounting the campaign, the server identifies members of the community having access to the called-for hardware and location.

9. Method as per any of Claim 5 through Claim 8
wherein,
when mounting the campaign, the premium is stipulated by means of bidding competition, auction, or at a fixed level.

10. Method as per any of Claim 4 through Claim 9
wherein
the hardware comprises at least one primary sensor, such as a radar, lidar, optical, stereo-optical, or ultrasonic sensing system, and auxiliaries, such as a camera, GPS, distance, distance to ground, orientation, temperature, or humidity sensor, preferably integrated in a mobile device such as a smartphone, tablet PC, or optical head-mounted display.

11. Method as per Claim 10
wherein
the scan is validated by means of the auxiliaries or comparison to further scans uploaded by the community or versus commercially available information such as weather forecasts.

12. Method as per any of Claim 4 through Claim 11
wherein,
when mounting the campaign, based on availability of prior scans, the server optionally substitutes the setting for a similar setting relevant to the pertinent deficiency.

13. Data processing apparatus having means for carrying out a method as per any of the preceding claims.

14. Computer program comprising instructions which, when the program is executed by a computer, cause the computer to carry out the steps of a method as per any of Claim 1 through Claim 12.

15. Computer-readable data carrier having stored thereon the computer program of Claim 14.
